**Europäisches Patentamt**

(19) **European Patent Office**

**Office européen des brevets**

(11) Numéro de publication: **0 060 165**
**B1**

(12) # FASCICULE DE BREVET EUROPEEN

(45) Date de publication du fascicule du brevet:
**22.05.85**

(51) Int. Cl.⁴: **H 03 B 5/36**

(21) Numéro de dépôt: **82400291.9**

(22) Date de dépôt: **18.02.82**

(54) **Oscillateur à fréquence commandée comportant un élément piézoélectrique, et présentant une plage de variation de fréquence étendue.**

(30) Priorité: **03.03.81 FR 8104198**

(43) Date de publication de la demande:
**15.09.82 Bulletin 82/37**

(45) Mention de la délivrance du brevet:
**22.05.85 Bulletin 85/21**

(84) Etats contractants désignés:
**CH DE GB IT LI NL**

(56) Documents cités:
**DE - A - 2 739 057**
**FR - A - 2 254 148**
**FR - A - 2 276 732**
**FR - A - 2 394 203**
**US - A - 3 845 410**
**US - A - 3 958 190**
**US - A - 4 134 085**

(73) Titulaire: **COMPAGNIE D'ELECTRONIQUE ET DE PIEZO-ELECTRICITE - C.E.P.E., 44, rue de la Glacière, F-95100 Argenteuil (FR)**

(72) Inventeur: **Helle, Jacques, THOMSON-CSF SCPI 173, bld Haussmann, F-75360 Paris Cedex 08 (FR)**
Inventeur: **Charlet, Gérard, THOMSON-CSF SCPI 173, bld Haussmann, F-75360 Paris Cedex 08 (FR)**

(74) Mandataire: **Ruellan-Lemonnier, Brigitte et al, THOMSON-CSF SCPI 173, boulevard Haussmann, F-75379 Paris Cedex 08 (FR)**

## Description

La présente invention se rapporte à un oscillateur à fréquence commandée comportant un élément piézoélectrique et présentant une plage de variation de fréquence étendue.

Un oscillateur à fréquence commandée peut comporter en tant qu'élément de définition de fréquence soit un circuit à inductances, résistances et condensateurs, soit un élément piezoélectrique. Dans le premier cas, la plage de variation de fréquence peut être très étendue, mais la stabilité en fréquence est très mauvaise. Dans le second cas, lorsque l'élément piézoélectrique est un quartz, la stabilité en fréquence est très bonne, mais la page de variation de fréquence est très restreinte.

On connait de l'antériorité FR 2 254 148 un oscillateur à fréquence commandée comportant un élément piézo-électrique en tantalate de lithium et une inductance variable disposée en série avec celui-ci et permettant de faire varier la fréquence de l'oscillateur. Cet oscillateur ne possède aucun moyen spécifique permettant d'étendre la plage de fréquence utile, en évitant l'accrochage de l'oscillateur sur des fréquences parasites lorsqu'un seuil donné de variation de fréquence est atteint.

On connait de l'antériorité US 3 958 190 un oscillateur comprenant un cristal aux bornes duquel est branché une inductance destinée à compenser la capacité parallèle inhérente au cristal. Cette compensation n'a pas l'influence recherchée sur l'étendue de la plage de réglage de fréquence.

La présente invention a pour objet un oscillateur à fréquence commandée ayant à la fois une très bonne stabilité en fréquence et une plage de variation en fréquence la plus étendue possible.

L'oscillateur à fréquence commandée conforme à la présente invention comporte un élément piézoélectrique à facteur de surtension inférieur à celui du quartz, en particulier un élément en tantale ou niobate de lithium, caractérisé en ce qu'est disposé en parallèle sur cet élément piézoélectrique un circuit de linéarisation comportant une inductance en série avec un circuit parallèle comprenant une résistance et un condensateur.

La présente invention sera mieux comprise à la lecture de la description détaillée d'un mode de réalisation, pris comme exemple non limitatif et illustré par le dessin annexé sur lequel:

— la figure 1 est un schéma dudit mode de réalisation, et

— les figures 2 et 3 sont des courbes de variation de paramètres de certains éléments du circuit de la figure 1.

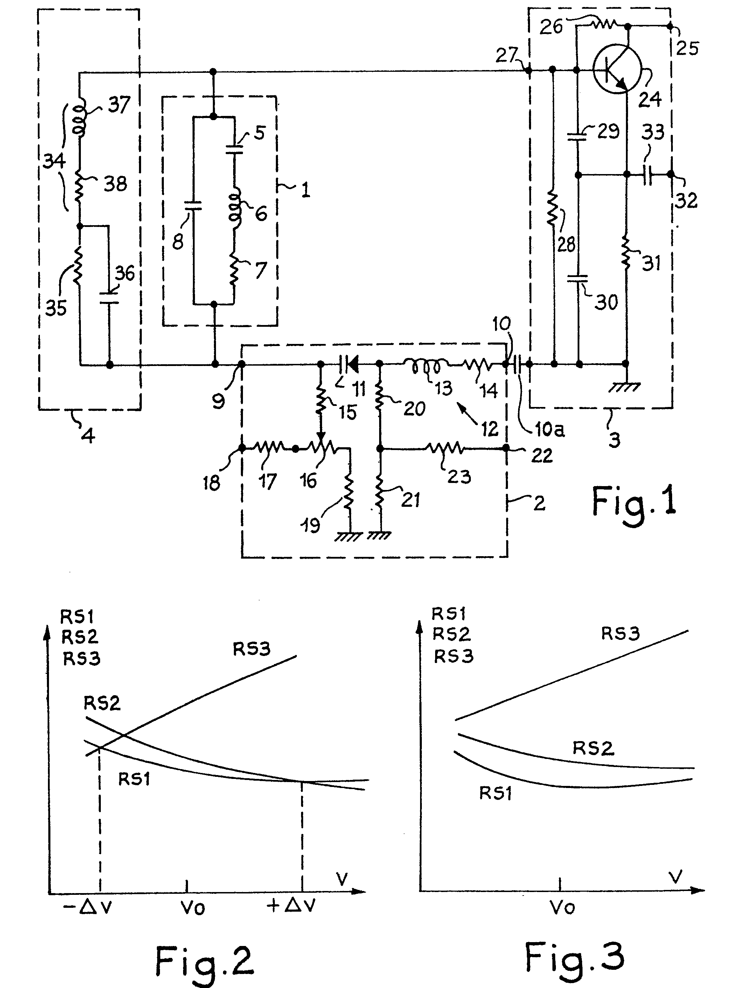

Le circuit oscillateur à fréquence commandée représenté sur la figure 1 du dessin comprend essentiellement un élément piézoélectrique 1 disposé en série avec un circuit 2 de réglage de fréquence dans la boucle de réaction d'un amplificateur 3, un circuit de linéarisation 4 étant disposé en parallèle avec l'élément piézoélectrique 1.

Sur la figure 1 du dessin, l'élément piézoélectrique 1 a été représenté par son circuit électrique équivalent. Ce circuit électrique équivalent comprend un circuit série formé d'un condensateur 5, d'une inductance 6 et d'une résistance 7, un condensateur 8 étant relié en parallèle sur ce circuit série. L'élément piézoélectrique 1 est par exemple en tantalate de lithium ou en niobate de lithium.

Le circuit 2 de réglage de fréquence comporte, entre une borne 9 reliée à l'élément piézoélectrique 1 et une borne 10 reliée à la masse de l'amplificateur 3, par un condensateur 10a un circuit série comprenant un élément 11 à capacité variable en fonction de la tension tel qu'une varicap, et une inductance 12. L'inductance 12 est représentée par son circuit série équivalent qui comprend un élément purement inductif 13 et un élément purement résistif 14. L'électrode de l'élément 11 reliée à la borne 9 est également reliée par une résistance 15 au curseur d'un potentiomètre 16. L'une des bornes du potentiomètre 16 est reliée par une résistance 17 à une borne 18 elle-même reliée à une source de tension de polarisation appropriée (non représentée). L'autre borne du potentiomètre 16 est reliée à la masse par une résistance 19. L'électrode de l'élément 11 reliée à l'inductance 12 est également reliée à la masse par deux résistances 20 et 21 disposées en série. Le point commun des résistances 20 et 21 est relié à une borne 22 par une résistance 23. La borne 22 est reliée à une source de tension de commande appropriée (non représentée). Cette source de tension de commande peut être tout dispositif, aussi bien manuel qu'automatique, commandant la variation de la fréquence du circuit oscillateur représenté sur le dessin en produisant une tension correspondante qui fait varier la capacité de l'élément 11. L'une au moins des résistances 17 et 19 peut être une varistance permettant de compenser au mieux la dérive thermique de l'élément piézoélectrique 1 et de ses circuits associés. Le circuit comprenant les éléments 15 à 23 est un exemple possible de circuit de commande de capacité de l'élément 11, mais il est bien entendu que d'autres circuits de commande réalisant la même fonction peuvent convenir.

L'amplificateur 3 représenté sur le dessin est un amplificateur classique du type «Clapp», mais il est bien entendu que l'invention n'est pas limitée à un tel amplificateur et que beaucoup d'autres amplificateurs peuvent convenir.

L'amplificateur 3 comporte un transistor 24, par exemple NPN dont le collecteur est relié à une borne 25 et à sa base par une résistance 26. La borne 25 est reliée à une source d'alimentation en tension appropriée (non représentée). La base du transistor 24 est également reliée d'une part à une borne 27, et d'autre part à la masse par un circuit parallèle constitué par une résistance 28 en parallèle avec un circuit série comportant deux condensateurs 29 et 30. L'émetteur du transistor 24 est relié d'une part au point commun des condensateurs 29 et 30, d'autre part à la masse par une résistance 31 et encore d'autre part à une borne 32 par un condensateur 33. La borne 32 constitue la borne de sortie de l'amplificateur 3 sur laquelle est disponible le signal de sortie du circuit oscillateur représenté sur le dessin. La borne 27 de l'amplificateur 3 est reliée au point commun de l'élément 1 et du circuit de linéarisation 4.

Le circuit de linéarisation 4 comporte une inductance 34 en série avec un circuit parallèle comprenant une résistance 35 en parallèle avec un condensateur 36. L'inductance 34 a été représentée par son circuit série équivalent qui comprend une inductance pure 37 et une résistance pure 38.

Le circuit oscillateur décrit ci-dessus peut osciller sur trois fréquences différentes déterminées par l'élément piézoélectrique 1 et les éléments associés des circuits 2 et 4. Soient FS1, FS2 et FS3 ces trois fréquences. La fréquence FS1, qui est la fréquence utile, est déterminée par les éléments 5, 6 de l'élément piézoélectrique 1 et par les éléments 11, 13 et 14 du circuit 2. La fréquence FS2 est déterminée par les éléments 8, 11, 13 et 14 et est supérieure à FS1. La fréquence FS3 est déterminée par les éléments 35, 36, 37 et 38 du circuit 4 et les éléments 11, 13 et 14 du circuit 2 et est inférieure à FS1. En fonction de la valeur des éléments précités, et en particulier de la valeur de l'élément 11, de circuit oscillateur oscille à la fréquence qui correspond à l'impédance ou à la résistance minimale. Si l'on suppose d'abord que les éléments 35 et 36, éléments essentiels de l'invention, ont une valeur nulle, et que l'on trace en fonction de la tension V appliquée à l'élément 11 les courbes de variation des résistances RS1, RS2 et RS3 correspondant chacune à la partie résistive du circuit série déterminant la fréquence d'oscillateur FS1, FS2 et FS3 respectivement, on obtient le diagramme de la figure 2. Sur ce diagramme de la figure 2, on référence $-\Delta V$ l'abscisse du point d'intersection des courbes correspondant à RS1 et RS3, et on référence $+\Delta V$ l'abscisse du point d'intersection des courbes correspondant à RS1 et RS2. On référence Vo le milieu du segment comprise entre $-\Delta V$ et $+\Delta V$.

On voit sur le diagramme de la figure 2 que lorsque la tension appliquée aux bornes de l'élément 11 est inférieure à $-\Delta V$, la résistance minimale est RS3, ce qui veut dire que le circuit oscillant oscille alors à la fréquence FS3. Lorsque la tension appliquée aux bornes de l'élément 11 est supérieure à $+\Delta V$, la résistance minimale est RS2, ce qui veut dire que le circuit oscillant oscille alors à la fréquence FS2.

Etant donné que la fréquence utile doit être FS1, on voit que la plage de variation de la tension est comprise entre $-\Delta V$ et $+\Delta V$, c'est-à-dire $Vo \pm \Delta V$ et qu'il y a risque de changement de fréquence d'oscillation aux limites de cette plage qui est relativement restreinte. Si Fo est la fréquence d'oscillation correspondant à la tension Vo appliquée à l'élément 11, la plage de variation de fréquence d'oscillation correspondant à une variation de la tension V autour de Vo, en deçà des limites $+\Delta V$ et $-\Delta V$, c'est-à-dire sans risque de brusque passage à la fréquence FS2 ou FS3, est d'environ $Fo \pm 10^{-3} Fo$, ce qui peut être insuffisant dans certains cas d'application.

On a constaté qu'en branchant, en série avec l'inductance 34, un circuit parallèle composé du condensateur 36 et de la résistance 35 de valeurs appropriées les courbes représentatives des variations de RS1, RS2 et RS3 s'éloignent les unes des autres, comme représenté sur la figure 3.

Le diagramme de la figure 3 étant tracé à la même échelle que celui de la figure 2, on voit que dans le cas de la figure 3 la courbe représentative de RS1 est située nettement en-dessous des deux autres courbes dans la plage $Vo \pm \Delta V$ et même au-delà. Ceci veut dire que la plage de variation de fréquence obtenue en faisant varier la tension appliquée aux bornes de l'élément 11 est nettement plus étendue que dans le cas illustré par la figure 2. On a ainsi pour obtenir des plages de variation de fréquence d'environ $Fo \pm 10^{-2} Fo$, ce qui est un grand progrès.

Le calcul des éléments du circuit 4 étant très complexe, il est préférable de procéder par essais successifs pour déterminer les valeurs de ce divers éléments. La détermination des autres éléments du circuit oscillateur étant bien connue en soi, ne sera pas exposée ici. L'influence de l'adjonction des éléments du circuit 4 sur les autres éléments du circuit de la figure 1 se limitant à l'éventuelle nécessité de choisir un élément 11 dont la variation de capacité soit suffisante pour permettre de couvrir toute la plage de variation de fréquence autorisée par le circuit de l'invention, l'homme de l'art peut facilement déterminer tous les éléments du circuit oscillateur.

Le tableau ci-dessous indique les valeurs des éléments du circuit 4 pour différentes fréquences nominales Fo, valeurs pratiquement optimales déterminées expérimentalement. La valeur de la résistance 38, qui représente la résistance ohmique de l'inductance 37 est moins critique que celle des autres éléments du circuit 4. Cette valeur de la résistance 38 peut être, dans les cas envisagés ci-dessous, de quelques ohms à quelques dizaines d'ohms pour des inductances réalisées de façon classique appropriée. Pour d'autres fréquences, on peut obtenir par interpolation des valeurs suffisamment approchées de la valeur optimale pour trouver facilement les valeurs optimales après un nombre réduit d'essais.

| Repère | 10 MHz | 18 MHz | 30 MHz |
|--------|--------|--------|--------|
| 35 | 75 Ω | 50 Ω | 45 Ω |
| 36 | 22 pF | 12 pF | 10 pF |
| 37 | 16 μH | 2,7 μH | 0,81 μH |

**Revendications**

1. Oscillateur à fréquence commandée comportant un élément piézoélectrique, et à plage de variation de fréquence étendue, l'élément piézoélectrique (1) ayant un facteur de surtension inférieur à celui du quartz et étant avantageusement en tantalate ou niobate de lithium, caractérisé par le fait qu'est disposé en parallèle sur cet élément piézoélectrique un circuit de linéarisation comprenant une inductance (34) en série avec un circuit parallèle comprenant une résistance et un condensateur (35, 36).

2. Oscillateur à fréquence commandé selon la revendication 1, pour un fonctionnement à 10 MHz environ, caractérisé par le fait que dans ledit circuit le linéarisation, l'inductance, la résistance et le condensateur ont pour valeurs respectives: 16 µH, 74 Ω et 22 pF, environ.

3. Oscillateur à fréquence commandée selon la revendication 1, pour un fonctionnement 18 MHz environ, caractérisé par le fait que dans ledit circuit de linéarisation, l'inductance, la résistance et le condensateur ont pour valeurs respectives: 2,7 µH, 50 Ω et 12 pF environ.

4. Oscillateur à fréquence commandée selon la revendication 1, pour un fonctionnement à 30 MHz environ, caractérisé par le fait que dans ledit circuit de linéarisation, l'inductance, la résistance et le condensateur ont pour valeurs respectives: 0,82 µH, 45 Ω et 10 pF.

## Patentansprüche

1. Oszillator mit gesteuerter Frequenz, der ein piezoelektrisches Element enthält und einen ausgedehnten Frequenzänderungsbereich aufweist, wobei das piezoelektrische Element (1) einen Güterfaktor aufweist, der kleiner als der eines Quarzes ist, und vorteilhafterweise aus Lithiumtantalat oder -niobat besteht, dadurch gekennzeichnet, dass parallel zu diesem piezoelektrischen Element ein Linearisierungskreis geschaltet ist, der eine Induktivität (34) in Reihe mit einer Parallelschaltung umfasst, die einen Widerstand und einen Kondensator (35, 36) enthält.

2. Oszillator mit gesteuerter Frequenz, nach Anspruch 1, für einen Betrieb bei etwa 10 MHz, dadurch gekennzeichnet, dass in dem Linearisierungskreis die Induktivität, der Widerstand und der Kondensator einen Wert von etwa 16 µH bzw. 75 Ω bzw. 22 pF aufweisen.

3. Oszillator mit gesteuerter Frequenz, nach Anspruch 1, für einen Betrieb bei etwa 18 MHz, dadurch gekennzeichnet, dass in dem Linearisierungskreis die Induktivität, der Widerstand und der Kondensator einen Wert von etwa 2,7 µH bzw. 50 Ω bzw. 12 pF aufweisen.

4. Oszillator mit gesteuerter Frequenz, nach Anspruch 1, für einen Betrieb bei etwa 30 MHz, dadurch gekennzeichnet, dass in dem Linearisierungskreis die Induktivität, der Widerstand und der Kondensator einen Wert von 0,82 µH bzw. 45 Ω bzw. 10 pF aufweisen.

## Claims

1. Controlled frequency oscillator comprising a piezoelectric element and having an extended frequency variation range, the piezoelectric element (1) having a magnification factor smaller than that of quartz, and being advantageously of lithium tantalate or lithium niobate, characterized by the fact that this piezoelectric element is connected in parallel with a linearizing circuit comprising an inductance (34) in series with a parallel circuit comprising a resistor and a capacitor (35, 36).

2. Controlled frequency oscillator according to claim 1, for operating at a frequency of about 10 MHz, characterized by the fact that, in the linearizing circuit, the inductance, the resistor and the capacitor have substantially the following values: 16 µH, 75 Ω and 22 pF, respectively.

3. Controlled frequency oscillator according to claim 1, for operating at a frequency of about 18 MHz, characterized by the fact that, in the linearzing circuit, the inductance, the resistor and the capacitor have substantially the following values: 2.7 µH, 50 Ω and 12 pF, respectively.

4. Controlled frequency oscillator according to claim 1, for operating at a frequency of about 30 MHz, characterized by the fact that, in the linearizing circuit, the inductance, the resistor and the capacitor have the following values: 0.82 µH, 45 Ω and 10 pF, respectively.

Fig.1

Fig.2

Fig.3